# EUROPEAN PATENT APPLICATION

(11) **EP 4 607 579 A1**
(43) Date of publication of application: **27.08.2025**
(21) Application number: 25150690.3
(22) Date of filing: 08.01.2025
(51) Int. Cl.: H01L 21/768, H01L 23/48, H01L 25/065

(54) **3D INTEGRATED CIRCUIT INCLUDING PROTECTION CIRCUIT**

(30) Priority: 21.02.2024 KR 20240025314; 16.04.2024 KR 20240050823
(71) Applicant: Samsung Electronics Co., Ltd., Suwon-si, Gyeonggi-do 16677 (KR)
(72) Inventor: JUNG, Ilho, Suwon-si (KR); CHOI, Jong-Ryun, Suwon-si (KR); KIM, Ha-Young, Suwon-si (KR); ROH, Hyunjeong, Suwon-si (KR); SONG, Sung-Jun, Suwon-si (KR); CHO, Yongeun, Suwon-si (KR); CHAE, Kwanyeob, Suwon-si (KR)
(74) Representative: Marks & Clerk LLP

(57) **Abstract**

A 3D integrated circuit includes a first integrated circuit including a first substrate. A second integrated circuit is stacked on the first integrated circuit. A through via extends through the first substrate and electrically connects the first integrated circuit and the second integrated circuit to one another. A plurality of protection circuits is disposed at opposite sides of the through via in a keep-out zone surrounding the through via and is electrically connected to the through via.

## Description

### TECHNICAL FIELD

The present disclosure relates to an integrated circuit and, more specifically, to a three-dimensional (3D) integrated circuit (IC) including a protection circuit.

### DISCUSSION OF THE RELATED ART

As electronic devices such as portable electronic devices become smaller, semiconductor elements disposed therein have also become smaller and lighter. As semiconductor elements become smaller, three-dimensional (3D) integrated circuits (ICs) in which multiple chips are stacked upon each other over a base substrate are being manufactured so as to integrate more circuits within a limited space.

In the manufacture of integrated circuits, a process including charged ions, such as a plasma etching process, may be used. For example, during the manufacture of an integrated circuit, a lowest metal layer closest to the substrate may be connected to the gate poly of a metal-oxide semiconductor (MOS) transistor. In the plasma etching process step of forming or interconnecting metal layers, etc., the lowest metal layer absorbs charge from the plasma, forming a sufficiently high voltage, relative to the substrate, that can destroy the thin gate dielectric that separates the gate poly from the substrate. This is called plasma induced gate oxide damage or the antenna effect. This may cause yield and reliability issues for integrated circuits.

### SUMMARY

An embodiment according to the present disclosure attempts to provide a three-dimensional (3D) integrated circuit in which at least one protection circuit is disposed in a keep out zone (KoZ).

An embodiment according to the present disclosure attempts to provide a three-dimensional (3D) integrated circuit capable of reducing spatial overhead.

A 3D integrated circuit includes a first integrated circuit including a first substrate. A second integrated circuit is stacked on the first integrated circuit. A through via extends through the first substrate and electrically connects the first integrated circuit and the second integrated circuit to one another. A plurality of protection circuits is disposed at opposite sides of the through via in a keep-out zone surrounding the through via and is electrically connected to the through via.

According to an embodiment, the keep-out zone may be a zone around the through via that does not include any active or sensitive devices or components. For instance, the keep-out zone may comprise only passive devices or components. The keep-out zone may be a zone around the through via that would be subject to increased mechanical stress, thermal gradients, electrical interference, and/or manufacturing defects during manufacture of the through via. Accordingly, the keep-out zone may be provided to mitigate adverse effects arising from mechanical stress, thermal gradients, electrical interference, or manufacturing tolerances associated with manufacture of the through via, thereby ensuring the reliability and performance of the surrounding circuitry.

The keep-out zone may comprise a first keep-out zone and a second keep-out zone. For instance, the keep-out zone may be a general keep-out zone comprising the first and second keep-out zones. The first keep-out zone may include an area spaced apart from an outer edge of the through via by a first distance in a first direction. The first keep-out zone may include an area covering a range from an outer edge of the through via to a first distance from the outer edge of the through via in the first direction. The first distance may be 2 µm to 4 µm. For instance, the first distance may be 3 µm. The second keep-out zone may include an area spaced apart from an outer edge of the through via by a second distance in the first direction, wherein the second distance is greater than the first distance. The second keep-out zone may include an area covering a range from the first keep-out zone to a second distance from the outer edge of the through via in the first direction. The second distance may be greater than or equal to 5 µm and/or less than or equal to 9 µm. The second keep-out zone may be positioned outside of the first keep-out zone.

In one embodiment, the first keep-out zone may not comprise any metal layer other than one or more metal layers that are connected to the through via. In one embodiment, active components may be excluded from the first keep-out zone. In one embodiment, the first keep-out zone is a keep-out zone in a back-end-of-line (BEOL) process.

In one embodiment, active components may be excluded from the second keep-out zone. The protection circuits may be passive circuits. In one embodiment, the second keep-out zone is a keep-out zone in a front-end-of-line (FEOL) process.

Each protection circuit may be configured to provide a current path (e.g. to/from one or both of a power supply voltage and a ground voltage) in response to a voltage being applied to a node of the protection circuit that exceeds a particular threshold voltage. For instance, each protection circuit may comprise one or more diodes. For instance, each protection circuit may comprise one or both of: a first diode between the node and a power supply voltage node, and a second diode between the node and a ground voltage node. A current path through one or both of the diodes may be provided in response to the voltage at the node exceeding a threshold (e.g. in response to a voltage difference across the respective diode being greater than a breakdown voltage of the respective diode). The node of each protection circuit may be connected to one or more of the plurality of metal layers that are connected to the through via.

An integrated circuit includes a through via extending through the first substrate. A first keep-out zone is disposed on the first substrate, and has a first boundary around the through via and spaced apart from the through via by a first distance in a first direction, and a second boundary spaced apart from the through via by a second distance in a second direction perpendicular to the first direction. A second keep-out zone is disposed on the first substrate, and has a third boundary around the through via and spaced apart from the through via by a third distance in the first direction, and a fourth boundary spaced apart from the through via by the second distance in the second direction. A first protection circuit is disposed outside of the first keep-out zone and inside of the second keep-out zone and is electrically connected to the through via. An integrated circuit is disposed outside of the second keep-out zone and includes an interface circuit electrically connected to the through via.

At least some of the above and other features of the invention are set out in the claims

### BRIEF DESCRIPTION OF THE DRAWINGS

A more complete appreciation of the present disclosure and many of the attendant aspects thereof will be readily obtained as the same becomes better understood by reference to the following detailed description when considered in connection with the accompanying drawings, wherein:
FIG. 1 is a perspective view illustrating a three-dimensional (3D) integrated circuit including a through via according to an embodiment.
FIG. 2 is a schematic diagram illustrating a TSV cell and a protection circuit according to a comparative embodiment.
FIG. 3 is a schematic diagram illustrating a TSV cell according to an embodiment.
FIG. 4 is a schematic diagram illustrating a TSV cell according to an embodiment.
FIG. 5 is a cross-sectional view taken along a line A-A' of FIG. 4.
FIG. 6 is a schematic diagram illustrating a TSV cell according to an embodiment.
FIG. 7 is a perspective view showing a cross-section taken along a line B-B' of FIG. 6.
FIG. 8 is a schematic diagram illustrating an effect of reducing an area occupied by a protection circuit according to an embodiment.
FIG. 9 is a schematic diagram illustrating a layout of an integrated circuit.
FIG. 10 is a schematic diagram illustrating a TSV area according to a comparative embodiment.
FIG. 11 is a schematic diagram illustrating a TSV area according to an embodiment.
FIG. 12 is a schematic diagram illustrating a signal transmission path of a logical signal according to an embodiment.
FIG. 13 is a perspective view illustrating a semiconductor device according to an embodiment.

### DETAILED DESCRIPTION OF THE DRAWINGS

In the following detailed description, certain embodiments of the present disclosure have been shown and described, simply by way of illustration. As those skilled in the art would realize, the described embodiments may be modified in various different ways, all without departing from the scope of the present disclosure.

While each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present disclosure, for example, to allow for manufacturing limitations and the like. In addition, in the following description, the formation of the first structure on or above the second structure may include embodiments in which the first and second structures are formed in direct contact, and embodiments may also include where additional structures may be formed between the first and second structures such that the first and second structures are not in direct contact.

In addition, spatially related terms, such as "below", "lower", "lower portion", "above", "upper portion", etc., may be used for ease of description to depict the relationship of any one element or structure illustrated in the drawing to another element or structure. For instance, these related terms may be defined relative to a vertical direction of the device. The vertical direction of the device may be perpendicular to an upper surface of a first substrate. It will be appreciated that these terms are relative to the structure of the device, and need not imply any particular orientation of the device in use.

Like reference numerals may designate like elements throughout the specification and the drawings.

In addition, expressions written in the singular may be construed in the singular or plural unless an explicit expression such as "one" or "single" is used. Terms including ordinal numbers such as first, second, and the like will be used to describe various component and are not necessarily to be interpreted as limiting these components. These terms may be used for the purpose of distinguishing one constituent element from other constituent elements.

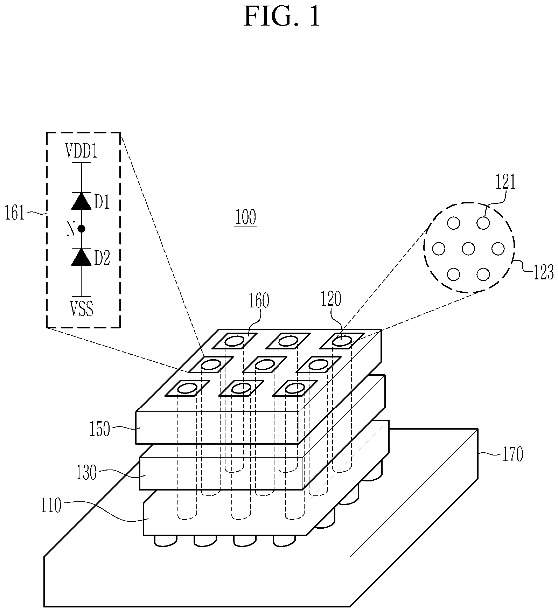

FIG. 1 illustrates a three-dimensional (3D) integrated circuit including a through via according to an embodiment. In an embodiment, a through via may be a through silicon via (TSV), but the present disclosure is not necessarily limited thereto.

Referring to FIG. 1, a three-dimensional integrated circuit (3D IC) 100 may include integrated circuits 110, 130, and 150 and a printed circuit board (PCB) 170. Each of the integrated circuits 110, 130, and 150 of the 3D integrated circuit 100 may be connected by through vias 120. Each of the integrated circuits 110, 130, and 150 may transmit and receive logic signals or power voltages through the through vias 120.

In an embodiment, at least one through via 120 may form a unit through via structure 123. The unit through via structure 123 may include a plurality of through vias 121. The through vias 121 may be arranged regularly (e.g., at regular intervals). For example, each of the integrated circuits 110, 130, and 150 may transmit and receive logic signals or power voltages through the unit through via structure 123. Hereinafter, the through via 121 may refer to any through via 121 among the through vias included in the unit through via structure 123.

Bumps (e.g., micro bumps or solder bumps) or hybrid copper bonding (HCB) may be disposed between the integrated circuits 110, 130, and 150. The integrated circuits 110, 130, and 150 may be electrically connected through bumps or hybrid copper bonding disposed between the integrated circuits 110, 130, and 150. The integrated circuits 110, 130, and 150 may transmit and receive logic signals or power voltages through bumps or hybrid copper bonding disposed between the integrated circuits 110, 130, and 150.

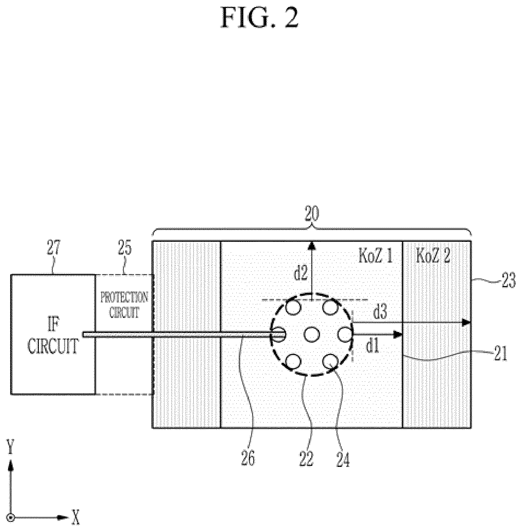

The first integrated circuit 150 may include an area (i.e., keep-out zone (KoZ)) 160 where circuits are selectively disposed to prevent defects caused by formation of the through via 121. For example, a circuit or metal layer might not be disposed in the keep-out zone 160 by setting the keep-out zone 160 to be spaced apart from the through via 121 by a predetermined distance, in order to prevent carrier mobility of active silicon existing near the through via 121 from being reduced. The keep-out zone 160 may include a keep-out zone in a front-end-of-line (FEOL) process and a keep-out zone in a back-end-of-line (BEOL) process. A detailed description thereof will be provided later with reference to FIG. 2. Hereinafter, the keep-out zone 160 including the through via 121 may be referred to as a TSV cell.

In an embodiment, the TSV cell may include a protection circuit 161. The protection circuit 161 may be disposed in the keep-out zone 160. The protection circuit 161 may protect the integrated circuit from an electrical effect occurring during a manufacturing process of the integrated circuit. For example, the protection circuit 161 may protect the first integrated circuit 150 by preventing an antenna effect or electrostatic discharge (ESD). Hereinafter, the protection circuit 161 is illustrated and described as including a plurality of diodes, but a configuration of the protection circuit 161 is not necessarily limited thereto.

The integrated circuit includes a transistor, and a gate electrode of the transistor may include a first layer and a second layer. Herein, the first layer may include a metal, and the second layer may include a polysilicon layer. A polysilicon layer in a gate electrode may be called a gate poly. In the following, the second layer is described as the polysilicon layer of the gate electrode of the transistor.

In the 3D integrated circuit 100, an antenna effect may occur due to damage to a gate poly due to charge generated during an etching operation of the through via 121. For example, the gate poly of the MOS transistor on the first integrated circuit 150 may be connected to the through via 121 through a metal layer. In a manufacturing process of an integrated circuit, charge due to a plasma etching process accumulate in a floating gate poly on the first integrated circuit 150, which may destroy a gate dielectric material. To prevent this problem, the 3D integrated circuit 100 may include the protection circuit 161 disposed in the TSV cell.

In an embodiment, the protection circuit 161 may include a first diode D1 connected between a node N and a line of a first power VDD1 and a second diode D2 connected between the node N and a line of a ground power VSS. The first diode D1 and the second diode D2 may be connected in a reverse direction. An anode of the first diode D1 may be connected to the node N, and a cathode of the first diode D1 may be connected to the first power VDD1 having a higher voltage level than that of the node N. A cathode of the second diode D2 may be connected to the node N, and an anode of the second diode D2 may be connected to the ground power VSS having a lower voltage level than that of the node N. When a voltage of a signal level within a normal operating range (e.g. a voltage less than a breakdown voltage of the diodes D1 and D2) is applied to the node N, each diode (D1 and D2) is reverse biased and therefore does not conduct. However, when a high voltage (e.g. a voltage greater than the breakdown voltage of the diodes D1 and D2) is applied to the node N, the diodes D1 and D2 become conductive due to strong reverse bias, and a charge due to static electricity may be discharged directly to the line of the first power VDD1 or the line of the ground power VSS. For example, the protection circuit 161 may create another electrical path for discharging charge. That is, the protection circuit 161 may create an electrical path for discharging charge that avoids a high build up of charge causing damage to the transistor(s). However, a structure of the protection circuit 161 is illustrative, and the present disclosure is not necessarily limited thereto.

According to an embodiment, an area occupied by the protection circuit 161 in the first integrated circuit 150 may be reduced by providing the protection circuit 161 in the keep-out zone 161, and thus an area of the first integrated circuit 150 may be efficiently utilized.

FIG. 2 illustrates a view for describing a TSV cell and a protection circuit according to a comparative embodiment.

Referring to FIG. 2, the TSV cell 20 may include a through via 24. At least one through via 24 may be disposed. The at least one through via 24 may form a unit through via structure 22. The unit through via structure 22 may include a plurality of through vias 24. The plurality of through vias 24 may be regularly arranged. A boundary 21 of a first keep-out zone KoZ 1 and a boundary 23 of a second keep-out zone (KoZ 2) are determined by a distance from an edge of an outermost through via of the unit through-via structure 22. For example, a boundary of the first keep-out zone KoZ 1 in the first direction (e.g., X direction) may be spaced apart from the outermost through via (e.g. the outermost through via in the first direction) by a first distance d1 in the first direction, and a boundary of the first keep-out zone KoZ 1 in the second direction (e.g., Y direction) may be spaced apart from the outermost through via (e.g. the outermost through via in the second direction) by a second distance d2 in the second direction. The first direction and the second direction may be perpendicular, and the first distance d1 and the second distance d2 may be the same or different from each other. The first direction and the second direction may both be perpendicular to a vertical direction of the device (e.g. perpendicular to an extension direction of the at least one through via 24). A boundary of the second keep-out zone KoZ 2 in the first direction (e.g., X direction) may be spaced apart from the outermost through via (e.g. the outermost through via in the first direction) by a third distance d3 in the first direction, and a boundary of the second keep-out zone KoZ 2 in the second direction (e.g., Y direction) may be spaced apart from the outermost through via (e.g. the outermost through via in the second direction) by the second distance d2 in the second direction. The first distance d1 and the third distance d3 may be different from each other, and the third distance d3 may be greater than the first distance d1. A boundary 23 of the second keep-out zone KoZ 2 is expanded from a boundary 21 of the first keep-out zone KoZ 1 in the first direction (e.g., X direction) and in a direction opposite to the first direction. The second keep-out zone KoZ 2 may be an area extended from the first keep-out zone KoZ 1 in the first direction. The first keep-out zone KoZ 1 may be a smaller area than the second keep-out zone KoZ 2. For example, the second keep-out zone KoZ 2 may occupy a larger area than the first keep-out zone KoZ 1.

The outermost through via may vary depending on the direction being considered. For instance, the outermost via in the first direction may be different to the outermost via in the second direction.

The second keep-out zone KoZ 2 may be an area in which active semiconductor devices (i.e., transistors used to transmit/process signals) are not disposed. For instance, the second keep-out zone KoZ 2 may be an area in which active semiconductor devices formed during the FEOL process are not disposed. For instance, the second keep-out zone KoZ 2 may include no active semiconductor devices. The FEOL process may form various layers and patterns necessary for the functioning of active semiconductor devices. For instance, an FEOL process may be a process for forming active semiconductor components. The second keep-out zone KoZ 2 may be an area where active semiconductor devices are not disposed in order to prevent interference between the through via 24 and the active semiconductor devices.

The first keep-out zone KoZ 1 may be an area in which metal layers, vias, etc. formed during the BEOL process are not disposed. The BEOL process may form metal layers to connect active semiconductor devices and other components. The first keep-out zone KoZ 1 may be an area in which metal layers other than predefined metal layers (e.g., metal layers connected to through-silicon vias) are not disposed to prevent interference between the through via 24 and the metal layers. For instance, no metal layers other than those metal layers connected to the through via 24 may be formed in the first keep-out zone KoZ 1.

The through via 24 of the TSV cell 20 may transmit a logic signal received from an adjacent interface circuit 27 to another integrated circuit, or may transmit logic signals received from other integrated circuits to the interface circuit 27. The through via 24 and the interface circuit 27 may be connected through a plurality of metal layers 26. Herein, the interface circuit 27 may include various logic elements. For example, the interface circuit 27 may be various logic elements such as AND gates, OR gates, NOR gates, XOR gates, inverters, etc., or memory elements such as latches and flip-flops.

A protection circuit 25 may be disposed on a path between the through via 24 and the interface circuit 27. For example, the protection circuit 25 may be connected to the metal layer 26 connecting the through via 24 and the interface circuit 27. The protection circuit 25, according to a comparative embodiment, may be disposed outside of the TSV cell 20. The protection circuit 25, according to the comparative embodiment, may be disposed adjacent to the TSV cell 20 outside of the TSV cell 20. The protection circuit 25, according to the comparative embodiment, may be disposed between the interface circuit 27 and the TSV cell 20 outside of the TSV cell 20.

According to the comparative example, the protection circuit 25 disposed outside of the TSV cell 20 occupies a large area within the integrated circuit. For example, there is a problem that the area of the integrated circuit might not be efficiently utilized due to the protection circuit 25 being disposed outside of the TSV cell 20.

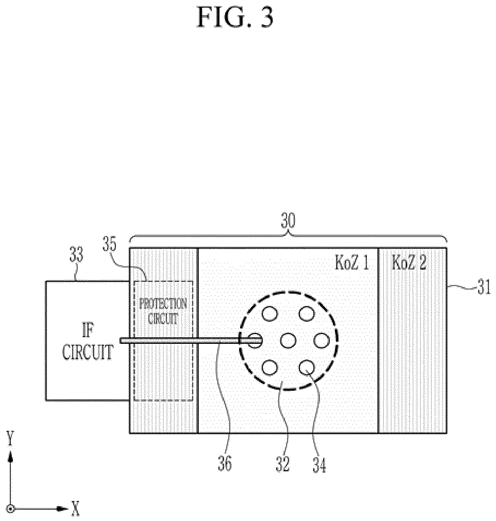

FIG. 3 illustrates a view for describing a TSV cell according to an embodiment. For example, it illustrates a schematic layout diagram to describe a TSV cell including a protection circuit.

In an embodiment, the TSV cell 30 may include a protection circuit 35. For example, the protection circuit 35 may be disposed in the second keep-out zone KoZ 2 of the TSV cell 30. The protection circuit 35 includes a passive semiconductor device (e.g. a device that does not include a transistor to transmit/process signals), and thus it is disposed in the second keep-out zone KoZ 2 (i.e. inside a boundary 31 of the TSV cell). A passive device may be a device that does not include any active devices (e.g. transistors), and therefore includes only passive components. A passive device or component may be a device or component that does not require an external power source to operate. A passive device or component may not amplify or generate energy. Examples of passive devices include resistors, capacitors, inductors, diodes and transformers. For instance, the protection circuit 35 may comprise one or more diodes.

If the protection circuit 35 is disposed too close to the through via 34, unexpected damage may occur in the protection circuit 35 during the manufacturing process, so the protection circuit 35 may be disposed outside of the first keep-out zone KoZ 1. The protection circuit 35 may be an antenna protection circuit (e.g., antenna diode, etc.) to prevent antenna effects, or an ESD protection circuit (e.g., an ESD diode, a clamp, etc.) to prevent ESD, but the present disclosure is not necessarily limited thereto.

In an embodiment, the TSV cell 30 and an interface circuit 33 may be disposed adjacent to each other in the first direction (e.g., X direction). The through via 34 of the TSV cell 30 may transmit a logic signal received from an adjacent interface circuit 33 to another integrated circuit, or may transmit logic signals received from other integrated circuits to the interface circuit 33. The through via 34 and the interface circuit 33 may be connected through a plurality of metal layers 36.

In an embodiment, the protection circuit 35 within the TSV cell 30 may be disposed on a path between the interface circuit 33 and the through via 34. For example, the protection circuit 35 may be connected to a plurality of metal layers 36 connecting the interface circuit 33 and the through via 34. The protection circuit 35, which is an electrical path for discharging charge flowing toward the interface circuit 33, may protect the transistors in the interface circuit 33 from various electrical effects.

According to an embodiment, an area of the integrated circuit may be efficiently utilized by positioning the protection circuit 25 within the TSV cell 20. For example, a size of the integrated circuit may be reduced or a sufficient area where logic elements may be disposed on the integrated circuit may be secured.

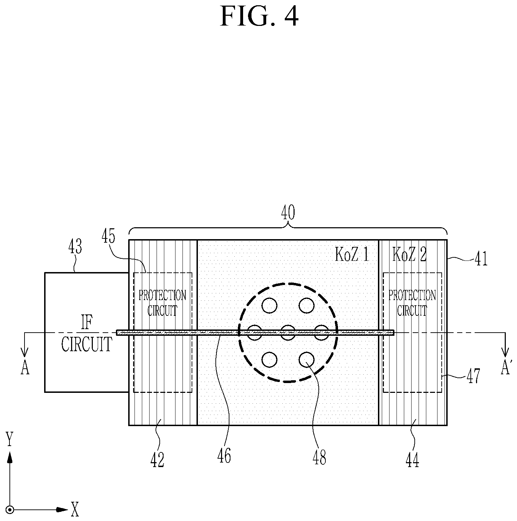

FIG. 4 illustrates a view for describing a TSV cell according to an embodiment. For example, it illustrates a schematic layout diagram to describe a TSV cell including a plurality of protection circuits.

In an embodiment, the TSV cell 40 may include protection circuits 45 and 47. The second keep-out zone KoZ 2 of the TSV cell 40 may include a first area 44 extending from the first keep-out zone KoZ 1 in the first direction (e.g., X direction), and a second area 42 extending in a direction opposite to the first direction. The TSV cell 40 may include a protection circuit 47 disposed in the first area 44 and a protection circuit 45 disposed in the second area 42. The protection circuits 45 and 47 may be disposed in the second keep-out zone KoZ 2 at opposite sides of a through via 48. The protection circuits 45 and 47 may be disposed outside of the first keep-out zone KoZ 1 at opposite sides of the through via 48. Structures of the protection circuits 45 and 47 may be the same or different from each other.

In an embodiment, the protection circuits 45 and 47 may be disposed on a path between an interface circuit 43 and the through via 48. For example, the protection circuits 45 and 47 may be connected to the metal layer 46 connecting the interface circuit 43 and the through via 48. The protection circuits 45 and 47, which are an electrical paths for discharging charge flowing toward the interface circuit 43, may protect the transistors in the interface circuit 43 from various electrical effects. According to an embodiment, the TSV cell 40 may include a plurality of protection circuits, further increasing the protection effect for transistors around the TSV cell through the protection circuits without increasing an area occupied by the protection circuits in the integrated circuit.

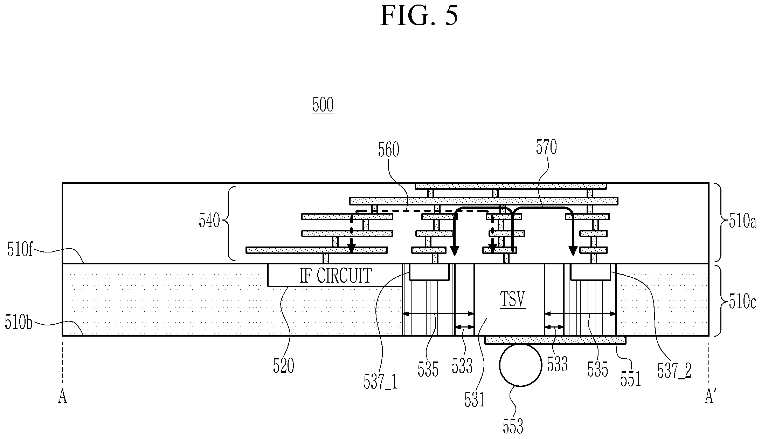

FIG. 5 illustrates a cross-sectional view taken along a line A-A' of FIG. 4.

For example, FIG. 5 illustrates a cross-sectional view of one integrated circuit 500 among a plurality of integrated circuits constituting a 3D integrated circuit. Referring to FIG. 5, according to an embodiment, the 3D integrated circuit may further include additional integrated circuits above and/or below the integrated circuit 500. For example, the integrated circuit 500 may correspond to the first integrated circuit 150 according to FIG. 1. Additionally, although a portion of integrated circuit 500 is shown here, the integrated circuit 500 may include additional components.

In an embodiment, the integrated circuit 500 may include a BEOL layer 510a and a substrate layer 510c. The substrate layer 510c may be or may include a semiconductor substrate material such as silicon. An interface circuit 520 that transmits and receives logic signals to and from other adj acent dies may be disposed on and/or within the substrate layer 510c. The interface circuit 520 may comprise active elements such as transistors (e.g. MOS transistors). The substrate layer 510c may include a through via 531 extending through the substrate layer 510c. The through via 531 may extend from a front surface 510f to a back surface 510b of the substrate layer 510c.

In an embodiment, a boundary of the first keep-out zone KoZ 1 in the first direction (e.g., X direction) around the through via 531 is determined by a first distance 533 from the through via 531 in the substrate layer 510c. A boundary of the second keep-out zone KoZ 2 in the first direction (e.g., X direction) around the through via 531 may be determined by a second distance 535 from the through via 531. Referring to FIG. 2, as described above, the first keep-out zone KoZ 1 may be an area where metal layers, vias, etc. formed during the BEOL process are not disposed, and the second keep-out zone KoZ 2 may be an area where an active semiconductor device formed during the FEOL process is not disposed. In FIG. 5, the first keep-out zone KoZ 1 and the second keep-out zone KoZ 2 are shown extending through the substrate layer 510c, but this is for convenience of understanding, and in fact, the first keep-out zone KoZ 1 and the second keep-out zone KoZ 2 are areas around the through via 531 on the substrate layer 510c, and might not extend through the substrate layer 510c.

In an embodiment, the substrate layer 510c may include protection circuits 537 disposed on and/or within the substrate layer 510c. The protection circuits 537 may be disposed in the second keep-out zone KoZ 2 and outside of the first keep-out zone KoZ 1. The protection circuits 537 may be disposed outside of the first keep-out zone KoZ 1 and inside of the second keep-out zone KoZ 2 at opposite sides of the through via 531.

In an embodiment, the interface circuit 520 may be disposed adjacent to the first protection circuit 537_1 among the protection circuits 537 in the first direction (e.g., X direction). The first protection circuit 537_1 may be disposed between the interface circuit 520 and the through via 531 in the first direction (e.g., X direction). In an embodiment, the interface circuit 520, a protection circuit 537_1, and the through via 531 may be sequentially disposed in the first direction X. Additionally, a second protection circuit 537_2 may be further disposed at an opposite side of the protection circuit 537_1 centered on the through via 531. The through via 531 may be located between the first protection circuit 537_1 and the second protection circuit 537_2.

In an embodiment, the BEOL layer 510a may include a plurality of metal layers 540. The metal layers 540 may include a plurality of metal lines and a plurality of metal vias connecting them. The interface circuit 520 may be electrically connected to the through via 531 through the metal layers 540. For example, the interface circuit 520 may transmit logic signals to the through via 531 or receive logic signals from the through via 531 through the metal layers 540. The interface circuit 520 may transmit and receive logic signals to and from the through via 531 through a first path 560.

In an embodiment, the protection circuits 537 may be electrically connected to the through via 531 through the metal layers 540. The protection circuits 537 may be electrically connected to the interface circuit 520 through the metal layers 540. For example, charge generated during an etching process to form the through via 531 may flow to the protection circuits 537 through a second path 570. Charge generated during the etching process to form the through via 531 may be discharged through the protection circuits 537 disposed in the second keep-out zone KoZ 2. In an embodiment, the protection circuit 537 may be connected to the metal layers 540 connecting the interface circuit 520 and the through via 531. The protection circuit 537, which is an electrical path for discharging charge flowing through the interface circuit 520, may protect the transistors in the interface circuit 520 from various electrical effects.

In an embodiment, a redistribution layer (RDL) 551 may be disposed on the back surface 510b of the substrate layer 510c to form an electrical connection with adjacent dies. The through via 531 may provide an electrical connection between the metal layers 540 and the redistribution layer 551 through conductive materials within the through via 531. The redistribution layer 551 may include a plurality of metallization patterns between adjacent dies. The redistribution layer 551 may form an electrical connection with the metal layers 540 through the conductive materials in the through via 531.

In an embodiment, the redistribution layer 551 may be connected to an interconnection structure 553. Herein, the interconnection structure 553 may include a bump (e.g., a micro bump or a solder bump) or hybrid copper bonding. The interconnection structure 553 may be formed of a conductive material such as copper, aluminum, etc. The interface circuit 520 may transmit and receive logic signals to and from the outside through the interconnection structure 553, the redistribution layer 551, the through via 531, the metal layers 540, etc. However, some of these elements may be omitted or other necessary elements may be added as needed.

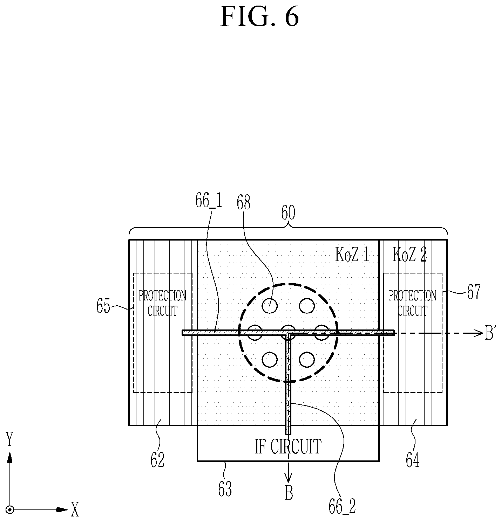

FIG. 6 illustrates a view for describing a TSV cell according to an embodiment. For example, it illustrates a schematic layout diagram to describe a TSV cell including a plurality of protection circuits.

In an embodiment, the TSV cell 60 may include protection circuits 65 and 67 disposed in the second keep-out zone KoZ 2 extended in the first direction X. The second keep-out zone KoZ 2 may include a first area 64 extending from the first keep-out zone KoZ 1 in the first direction (e.g., X direction) and a second area 62 extending in a direction opposite to the first direction, and each area may include protection circuits 65 and 67. The protection circuits 65 and 67 may be disposed in the second keep-out zone KoZ 2 at opposite sides of a through via 68. The protection circuits 65 and 67 may be disposed outside of the first keep-out zone KoZ 1 at opposite sides of the through via 68. Structures of the protection circuits 65 and 67 may be the same or different from each other. However, the present disclosure is not necessarily limited thereto, and one of the first area 64 and the second area 62 may include a protection circuit. The through via 68 and the protection circuits 65 and 67 may be connected through a plurality of metal layers 66_1.

In an embodiment, the TSV cell 60 and an interface circuit 63 may be disposed adjacent to each other in a second direction (e.g., Y) perpendicular to the first direction (e.g., X direction). The interface circuit 63 may be disposed adjacent to the first keep-out zone KoZ 1 in the second direction (e.g., Y). No element might be disposed between the interface circuit 63 and the first keep-out zone KoZ 1 in the second direction (e.g., Y). The through via 68 of the TSV cell 60 may transmit a logic signal received from an adjacent interface circuit 63 to another integrated circuit, or may transmit logic signals received from other integrated circuits to the interface circuit 63. The through via 68 and the interface circuit 33 may be connected through a plurality of metal layers 66_2.

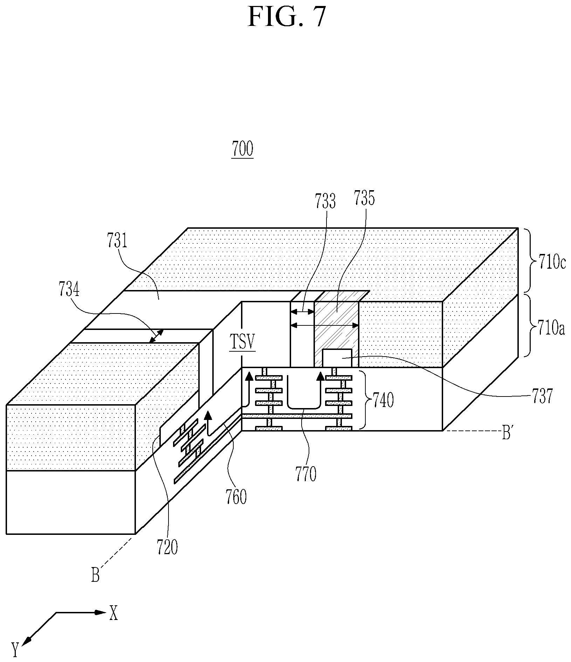

FIG. 7 illustrates a perspective view showing a cross-section taken along a line B-B' of FIG. 6.

For example, FIG. 7 illustrates a cross-sectional view of one integrated circuit 700 among a plurality of integrated circuits constituting a 3D integrated circuit. Referring to FIG. 7, according to an embodiment, the 3D integrated circuit may further include additional integrated circuits above and/or below the integrated circuit 700. For example, the integrated circuit 700 according to FIG. 7 may correspond to the first integrated circuit 150 according to FIG. 1. Additionally, although a portion of integrated circuit 700 is shown here, the integrated circuit 700 may include additional components. To the extent that an element is not described in detail with respect to this figure, it may be understood that the element is at least similar to a corresponding element that has been described elsewhere within the present disclosure.

In an embodiment, the integrated circuit 700 may include an interface circuit 720 disposed on and/or within the substrate layer 710c. The substrate layer 710c may include a through via 731 extending through the substrate layer 710c. On the substrate layer 710c, the first keep-out zone KoZ 1 around the through via 731 may be determined by a first distance 733 from the through via 731 in the first direction (e.g., X) and a second distance 734 in the second direction (e.g., Y) perpendicular to the first direction (e.g., X). On the substrate layer 710c, the second keep-out zone KoZ 2 around the through via 731 may be determined by a third distance 735 from the through via 731 in the first direction (e.g., X) and the second distance 734 in the second direction (e.g., Y) perpendicular to the first direction (e.g., X). The first distance 733 and the second distance 734 may be different from or the same as each other, and the third distance 735 may be greater than the first distance 733. Accordingly, the second keep-out zone KoZ 2 may occupy a larger area than the first keep-out zone KoZ 1.

In an embodiment, the integrated circuit 700 may include a protection circuit 737 disposed on and/or within the substrate layer 710c. The protection circuit 737 may be disposed in the second keep-out zone KoZ 2 and outside of the first keep-out zone KoZ 1.

In an embodiment, the interface circuit 720 may be disposed adjacent to the through via 731 in the second direction (e.g., Y) perpendicular to the first direction (e.g., X direction). The interface circuit 720 may be disposed adjacent to the first keep-out zone KoZ 1 in the second direction (e.g., Y) perpendicular to the first direction (e.g., X direction). No element might be disposed between the interface circuit 720 and the first keep-out zone KoZ 1 in the second direction (e.g., Y). The interface circuit 720 and the protection circuit 737 may be disposed in directions perpendicular to each other based on the through via 731, and may be disposed adjacent to the through via 731 in directions perpendicular to each other.

In an embodiment, the interface circuit 720 may transmit logic signals to or receive logic signals from the through via 731 through the metal layers 740 in the BEOL layer 710a. The interface circuit 720 may transmit and receive logic signals to and from the through via 731 by using a first path 760.

In an embodiment, the protection circuit 737 may be electrically connected to the through via 731 and the interface circuit 720 through the metal layers 740. For example, charge generated during an etching process to form the through via 731 may flow to the protection circuit 737 through a second path 770.

According to an embodiment, the semiconductor device 700 may minimize a distance between the interface circuit 720 and the through via 731. Accordingly, a length of the metal layer 740 connecting the interface circuit 720 and the through via 731 may be reduced, which may increase signal integrity (SI) and provide other desirable characteristics.

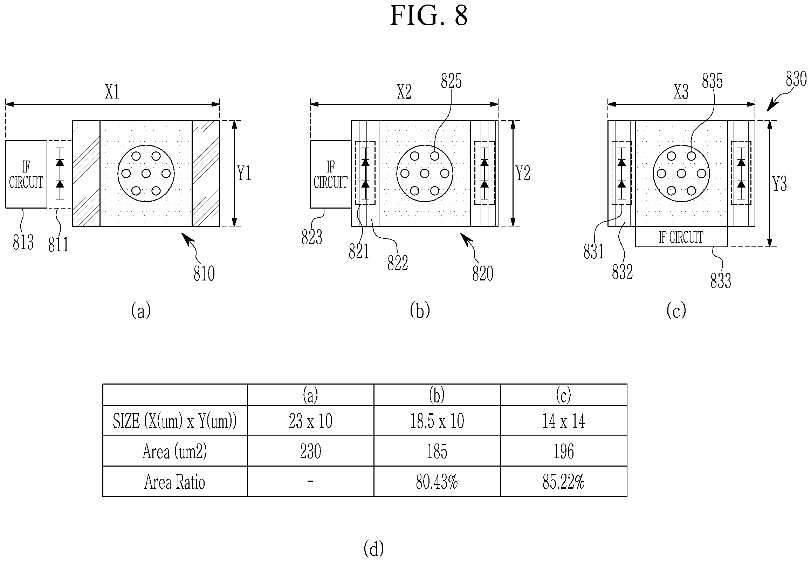

FIG. 8 illustrates a view for describing an effect of reducing an area occupied by a protection circuit according to an embodiment.

FIG. 8, element (a), illustrates a TSV cell 810, a protection circuit 811, and an interface circuit 813 according to a comparative example. According to the comparative example of FIG. 8, element (a), the protection circuit 811 is disposed outside of the TSV cell 810 and adjacent to the TSV cell 810, and the protection circuit 811 and the interface circuit 813 are disposed adjacent to each other in a same direction (e.g., first direction) as a direction in which the protection circuit 811 is adjacent to the TSV cell 810.

FIG. 8, element (b), illustrates a TSV cell 820, a protection circuit 821, and an interface circuit 823 according to an example. According to an example of FIG. 8, element (b), the protection circuit 821 is disposed in a FEOL keep-out zone 822 inside of the TSV cell 820, and the protection circuit 821 and the interface circuit 823 may be disposed adjacent to each other in a same direction as a direction in which the protection circuit 821 is disposed adjacent to the through via 825 (e.g., the first direction). Herein, the TSV cell 820 is illustrated as including a plurality of protection circuits 821, but the present disclosure is not necessarily limited thereto.

FIG. 8, element (c), illustrates a TSV cell 830, a protection circuit 821, and an interface circuit 823 according to an example. According to an example of FIG. 8, element (c), the protection circuit 831 may be disposed in a FEOL keep-out zone 832 inside of the TSV cell 830, and the TSV cell 820 and the interface circuit 823 may be disposed adjacent to each other in a direction perpendicular to a direction (first direction) in which the protection circuit 821 is disposed adjacent to the through via 835 (e.g., the second direction).

FIG. 8, element (d), is a table shown to compare areas occupied by the TSV cell, the protection circuit, and the interface circuit according to the comparative example FIG. 8, element (a), and the examples FIG. 8, element (b), and FIG. 8, element (c), of the present disclosure. According to the table in FIG. 8, element (d), a length X1 of the TSV cell 810, the protection circuit 811, and the interface circuit 813 in the first direction according to the comparative example of FIG. 8, element (a), is 23 µm, and a length Y1 in the second direction is 10 µm, and thus an area occupied by the TSV cell 810, the protection circuit 811, and the interface circuit 813 according to the comparative example of FIG. 8, element (a), is 230 µm². On the other hand, a length X2 of the TSV cell 820, the protection circuit 821, and the interface circuit 823 in the first direction according to the example of FIG. 8, element (b), is 18.5 µm, and a length Y2 in the second direction is 10 µm, and thus an area occupied by the TSV cell 820, the protection circuit 821, and the interface circuit 823 according to the example of FIG. 8, element (b), is 185 µm², and a length X3 of the TSV cell 830, the protection circuit 831, and the interface circuit 833 in the first direction according to the example of FIG. 8, element (c), is 14 µm, and a length Y3 in the second direction is 14 µm, and thus an area occupied by the TSV cell 830, the protection circuit 831, and the interface circuit 833 according to the example FIG. 8, element (c), is 196 µm2. For example, a boundary of the FEOL keep out zone 832 in the first direction (e.g., X direction) may be spaced apart from the outermost through via 835 (e.g. from the outermost through via in the first direction) by 5 µm to 9 µm in the first direction. For instance, the FEOL keep out zone 832 may have a first (e.g. inner) boundary spaced 2 µm to 4 µm (e.g. 3 µm) from the through via 835 (e.g. from the outermost through via in the first direction) and a second (e.g. outer boundary) spaced 5 µm to 9 µm from the through via 835.

For example, compared to the area according to the comparative example FIG. 8, element (a), the area occupied by the TSV cell, the protection circuit, and the interface circuit according to the examples FIG. 8, element (b), and FIG. 8, element (c), may be reduced by 19.57 % and 14.78 %, respectively. There is an advantage in that the area of the integrated circuit may be efficiently utilized by reducing the size of the semiconductor device or arranging other logic elements according to the reduced area.

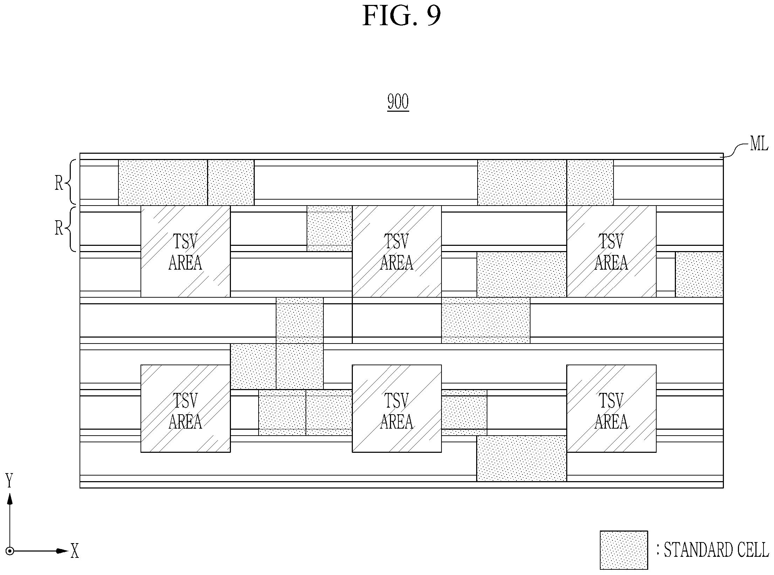

FIG. 9 schematically illustrates a layout of an integrated circuit. In an embodiment, the integrated circuit 900 may include a plurality of metal lines ML extending in a row direction (e.g., X direction). The metal lines ML may intersect to provide a power voltage (e.g., VDD) and a ground voltage VSS.

In an embodiment, the integrated circuit 900 may include a plurality of standard cells. Herein, the standard cells may include logic elements, memory elements, filler cells, etc. The standard cells may be arranged to overlap the metal lines ML. Herein, the standard cells arranged in each row R are shown, but the present disclosure is not necessarily limited thereto, and the standard cells may be formed over a plurality of rows R.

In an embodiment, the integrated circuit 900 may further include a TSV area. The TSV area may include a TSV cell including a through-via, a protection circuit, and an interface circuit for transmitting and receiving a logic signal to and from the through-via. TSV areas may be regularly arranged on the integrated circuit 900. For example, the TSV areas may be spaced apart from each other by a predetermined distance in the first direction (e.g., X) and the second direction (e.g., Y). Alternatively, the TSV areas may be irregularly arranged on the integrated circuit 900.

The TSV cell, the protection circuit, and the interface circuit may be implemented as one TSV module. In an embodiment, the TSV area may include TSV modules arranged in an m x n (m by n) format (where "m" and "n" are integers equal to or greater than 1). For example, the TSV area may include one TSV module or may include multiple TSV modules. In an embodiment, some of the TSV areas may include one TSV module, and remaining TSV areas may include a plurality of TSV modules arranged in an m x n (m by n) format.

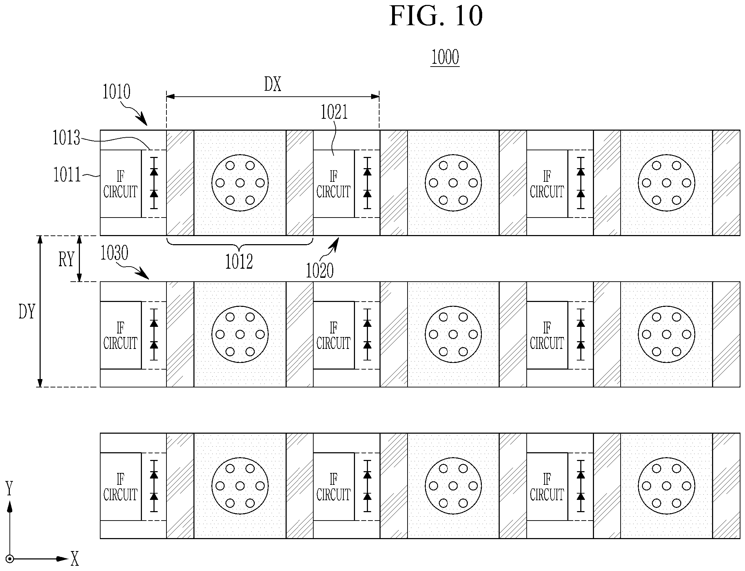

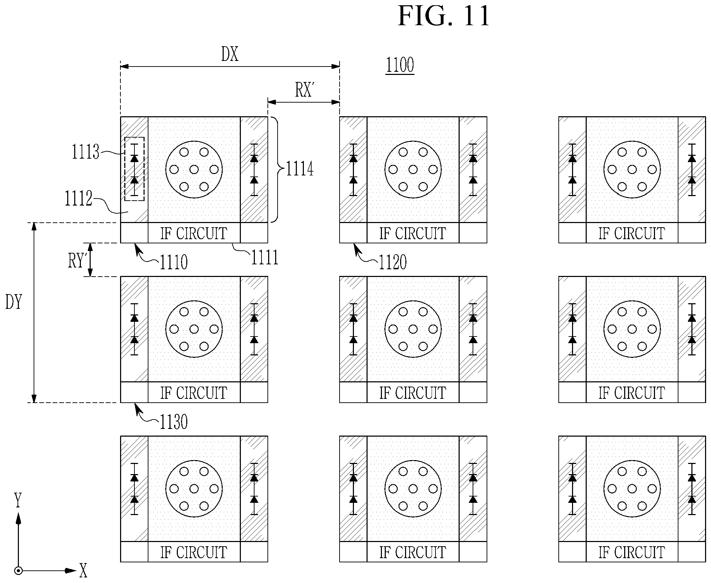

The TSV area may further include standard cells. The TSV area may include standard cells disposed in a remaining area after positioning the TSV module. A detailed description of the TSV area will be provided with reference to FIGS. 10 and 11.

FIG. 10 illustrates a TSV area according to a comparative embodiment. For example, the TSV area, according to the comparative embodiment of FIG. 10, is shown as including a plurality of TSV modules arranged in a 3 x 3 (3 by 3) shape, but the present disclosure is not necessarily limited thereto.

The TSV area 1000, according to the comparative embodiment, may include a plurality of TSV modules 1010, 1020, and 1030. The first TSV module 1010, according to the comparative embodiment, may include a TSV cell 1012, a protection circuit 1013, and an interface circuit 1011. The protection circuit 1013 in the first TSV module 1010, according to the comparative embodiment, may be disposed outside of the TSV cell 1012.

According to the comparative example, the first TSV module 1010 and the second TSV module 1020 may be spaced apart from each other by a predetermined first distance DX in the first direction (e.g., X direction). The first TSV module 1010 and the third TSV module 1030 may be spaced apart by a predetermined second distance DY in a second direction (e.g., Y direction) perpendicular to the first direction.

According to the comparative embodiment, an interface circuit 1021 that transmits and receives logic signals to and from a through via in the second TSV module 1020 may be disposed adjacent to the first TSV module 1010. For example, the interface circuit 1021 and the first TSV module 1010 may be attached and disposed in the first direction (e.g., X direction). Accordingly, no standard cell may be disposed between the interface circuit 1021 and the first TSV module 1010.

According to the comparative example, the first TSV module 1010 and the third TSV module 1030 may be arranged adjacent to each other in the second direction (e.g., Y direction). The first TSV module 1010 and the third TSV module 1030 may be spaced apart from one another by a third distance RY in the second direction (e.g., Y direction). A plurality of standard cells may be disposed between the first TSV module 1010 and the third TSV module 1030. Additionally, a plurality of metal layers may be disposed between the first TSV module 1010 and the third TSV module 1030.

According to the comparative embodiment, an area where standard cells can be disposed in the TSV area 1000 is merely an area of the third distance RY between the first TSV module 1010 and the third TSV module 1030. For example, many standard cells are disposed in a limited space, which may cause various problems such as routing congestion.

FIG. 11 illustrates a TSV area according to an embodiment. For example, the TSV area, according to an embodiment of FIG. 11, is shown as including a plurality of TSV cells a protection circuit, and an interface circuit arranged in a 3 x 3 (3 by 3) shape, but the present disclosure is not necessarily limited thereto. In addition, each of the TSV cell, the protection circuit, and the interface circuit may be implemented as one TSV module.

The TSV area 1100, according to an embodiment, may include a plurality of TSV modules 1110, 1120, and 1130. The first TSV module 1110, according to an embodiment, may include a TSV cell 1114, a protection circuit 1113, and an interface circuit 1111. The protection circuit 1113 in the first TSV module 1110, according to an embodiment, may be disposed inside of the TSV cell 1114. According to an embodiment, the protection circuit 1113 within the second TSV module 1110 may be disposed in the second keep-out zone KoZ 2 within the TSV cell 1114. A structure of the protection circuit 1113 is not necessarily limited thereto.

According to an embodiment, the first TSV module 1110 and the second TSV module 1120 may be spaced apart from each other by a predetermined first distance DX in the first direction (e.g., X direction). The first TSV module 1110 and the third TSV module 1130 may be spaced apart by a predetermined second distance DY in a second direction (e.g., Y direction) perpendicular to the first direction. In an embodiment, the first TSV module 1110 and the second TSV module 1020 are spaced apart by the first distance DX in the first direction (e.g., X direction), so that there may be a space equal to a third distance RX' in the first direction (e.g., X direction) between the first TSV module 1110 and the second TSV module 1020. In addition, the first TSV module 1110 and the third TSV module 1030 are spaced apart by the second distance DY in the second direction (e.g., Y direction), so that there may be a space equal to a fourth distance RY' in the second direction (e.g., Y direction) between the first TSV module 1110 and the third TSV module 1030.

In an embodiment, a plurality of standard cells may be located in an area of the third distance RX' and an area of the fourth distance RY'. For example, with the protection circuit disposed within the TSV cell, there is an advantage in that an area where standard cells can be disposed within the TSV area 1100 may increase (e.g. the design freedom for the placement of TSV cells may be increased), the area may be utilized efficiently, and problems such as routing congestion may be solved. Additionally, the TSV area 1100 according to an embodiment may reduce the first distance DX and the second distance DY as needed. For example, there is an advantage in that the area occupied by the TSV area 1100 in the integrated circuit may be reduced by arranging the TSV modules 1110, 1120, and 1130 closer to each other.

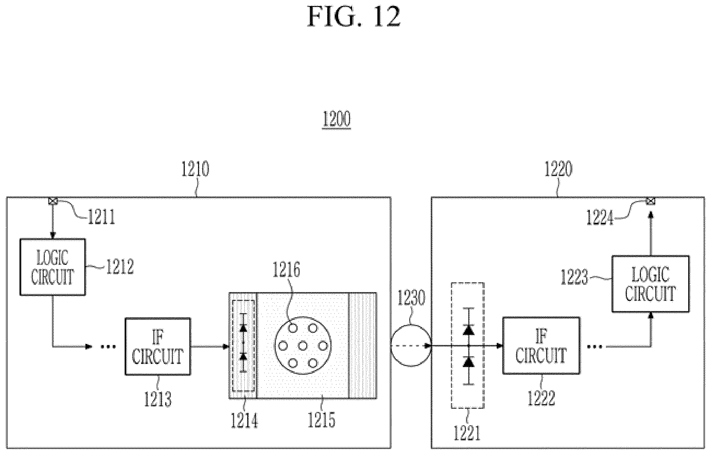

FIG. 12 illustrates a view for describing a signal transmission path of a logical signal according to an embodiment. For example, it represents a signal transmission path of a logic signal transmitted from a first integrated circuit to a second integrated circuit through a through-via.

In an embodiment, the 3D integrated circuit 1200 may include a first integrated circuit 1210 and a second integrated circuit 1220. The first integrated circuit 1210 may include a logic circuit 1212, an interface circuit 1213, and a TSV cell 1215. In an embodiment, the interface circuit 1213 and the TSV cell 1215 may be implemented as a TSV module. In an embodiment, the TSV cell 1215 may include a through-via 1216, and may include a protection circuit 1214 in a region spaced apart from the through-via 1216 by a predetermined distance. In an embodiment, the second integrated circuit 1220 may include an interface circuit 1222 and a logic circuit 1223. The second integrated circuit 1220 may further include a protection circuit 1221. However, as needed, some components within each die may be omitted, or other necessary components may be added.

In an embodiment, the first integrated circuit 1210 may receive a logic signal from the outside through an input port 1211. The logic signal may be transmitted to the through-substrate via 1215 through the logic circuit 1212 and the interface circuit 1213 in the first integrated circuit 1210. The logic signal may be transmitted to the second integrated circuit 1220 through an interconnection structure 1230. The logic signal may be transmitted to the outside through the interface circuit 1222 and the logic circuit 1223 in the second integrated circuit 1220 and through an output port 1224.

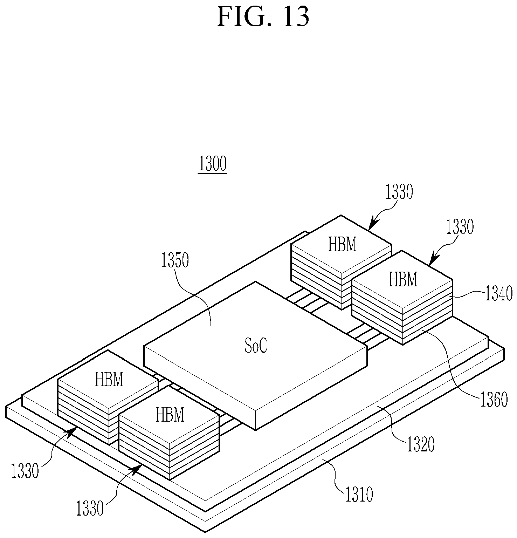

FIG. 13 illustrates a semiconductor device according to an embodiment.

Referring to FIG. 13, the semiconductor device 1300 may be a memory module including at least one stack semiconductor chip 1330 and a system-on-chip (SOC) 1350 mounted on a package substrate 1310 such as a printed circuit board.

An interposer 1320 may be optionally further provided on the package substrate 1310. The stack semiconductor chip 1330 may be formed as a chip-on-chip (CoC). The stack semiconductor chip 1330 may include at least one memory chip 1340 stacked on a buffer chip 1360 such as a logic chip. The buffer chip 1360 and at least one memory chip 1340 may be connected to each other by a through silicon via (TSV). In an embodiment, the buffer chip 1360 and the at least one memory chip 1340 may include the protection circuits and the interface circuits described with reference to FIGS. 1 to 12. Accordingly, the semiconductor device 1300 according to an embodiment may include a through substrate via that electrically connects stacked semiconductor chips 1330, and the at least one memory chip 1340 may include a first keep-out zone and a second keep-out zone around the through-substrate via. According to an embodiment, the semiconductor device 1300 may efficiently utilize an area of the semiconductor device 1300 by designing the protection circuit within the at least one memory chip 1340 to be disposed within the second keep-out zone around the through substrate via. In an embodiment, the stack semiconductor chip 1330 may be, e.g., a high bandwidth memory (HBM) having a bandwidth of 500 GB/sec to 1 TB/sec or more.

Embodiments are set out in the following Clauses:
Clause 1. A three-dimensional (3D) integrated circuit, comprising:
   a first integrated circuit including a first substrate;
   a second integrated circuit stacked on the first integrated circuit;
   a through via extending through the first substrate and electrically connecting the first integrated circuit to the second integrated circuit; and
   a plurality of protection circuits disposed at opposite sides of the through via in a general keep-out zone surrounding the through via and electrically connected to the through via.
Clause 2. The 3D integrated circuit of Clause 1, wherein the general keep-out zone includes:
   a first keep-out zone including an area spaced apart from an outer edge of the through via by a first distance in a first direction; and
   a second keep-out zone including an area spaced apart from an outer edge of the first keep-out zone by a second distance that is greater than the first distance from the through via in the first direction,
   wherein the plurality of protection circuits are disposed within the second keep-out zone.
Clause 3. The 3D integrated circuit of Clause 1 or Clause 2, further comprising
   an interface circuit which is adjacent to a first protection circuit among the plurality of protection circuits in the first direction outside of the second keep-out zone, and configured to transmit and receive logic signals to and from the second integrated circuit through the through via.
Clause 4. The 3D integrated circuit of Clause 3, wherein
   the second keep-out zone includes a first area and a second area outside of the first keep-out zone at opposite sides of the through via, and
   the first protection circuit is disposed in the first area, and a second protection circuit among the plurality of protection circuits is disposed in the second area.
Clause 5. The 3D integrated circuit of Clause 3 or Clause 4, wherein
   the through via and the interface circuit are electrically connected to one another using a plurality of metal layers, and the protection circuits are electrically connected to the plurality of metal layers.
Clause 6. The 3D integrated circuit of any of Clauses 2-5, further comprising:
   an interface circuit adjacent to the first keep-out zone outside of the second keep-out zone in a second direction perpendicular to the first direction, and configured to transmit and receive logic signals to and from the second integrated circuit through the through via.
Clause 7. The 3D integrated circuit of any of Clauses 2-6, wherein:
   the first keep-out zone is an area that does not include a metal layer other than the metal layer connected to the through via, and
   the second keep-out zone is an area in which an active semiconductor device is not disposed.
Clause 8. The 3D integrated circuit of any preceding Clause, wherein
   the protection circuits include an antenna protection circuit configured to provide antenna effect protection to the first integrated circuit.
Clause 9. The 3D integrated circuit of Clause 8, wherein
   the antenna protection circuit includes an antenna diode.
Clause 10. The 3D integrated circuit of any preceding Clause, wherein
   the plurality of protection circuits are electrostatic discharge (ESD) protection circuits configured to provide ESD protection to the first integrated circuit.
Clause 11. An integrated circuit, comprising:
   a through extending through a first substrate;
   a first keep-out zone disposed on the first substrate, and having a first boundary around the through via and spaced apart from the through via by a first distance in a first direction, and a second boundary spaced apart from the through via by a second distance in a second direction perpendicular to the first direction;
   a second keep-out zone disposed on the first substrate, and having a third boundary around the through via and spaced apart from the through via by a third distance in the first direction, and a fourth boundary spaced apart from the through via by the second distance in the second direction;
   a first protection circuit disposed outside of the first keep-out zone and inside of the second keep-out zone and electrically connected to the through via; and
   an integrated circuit disposed outside of the second keep-out zone and including an interface circuit electrically connected to the through via.
Clause 12. The integrated circuit of Clause 11, wherein
   the third distance is greater than the first distance.
Clause 13. The integrated circuit of Clause 11 or Clause 12, wherein
   the interface circuit, the first protection circuit, and the through via are sequentially arranged in the first direction.
Clause 14. The integrated circuit of any of Clauses 11-13, further comprising:
   a second protection circuit disposed outside of the first keep-out zone and inside of the second keep-out zone, and disposed at an opposite side of the first protection circuit with respect to the through via.
Clause 15. The integrated circuit of any of Clauses 11-14, wherein
   the interface circuit is disposed adjacent the first keep-out zone in the second direction.
Clause 16. The integrated circuit of Clause 15, wherein
   no element is disposed between the interface circuit and the first keep-out zone.
Clause 17. The integrated circuit of any of Clauses 11-16, wherein
   the first protection circuit includes an antenna protection circuit configured to provide antenna effect protection to a transistor located on the first substrate and an ESD protection circuit configured to provide ESD protection.
Clause 18. A three-dimensional (3D) integrated circuit comprising:
   a first substrate;
   a through via extending through the first substrate;
   a first keep-out zone disposed on the first substrate and including an area around the through via at a first distance from the through via;
   a second keep-out zone disposed on the first substrate and including an area extended by a second distance in a first direction from the first keep-out zone and in a direction opposite to the first direction;
   a protection circuit disposed outside of the first keep-out zone and inside of the second keep-out zone and electrically connected to the through via; and
   an interface circuit adjacent to the first keep-out zone in a second direction perpendicular to the first direction and electrically connected to the through via.
Clause 19. The 3D integrated circuit of Clause 18, wherein
   the first keep-out zone is a keep-out zone in a back-end-of-line (BEOL) process, and the second keep-out zone is a keep-out zone in a front-end-of-line (FEOL) process.
Clause 20. The 3D integrated circuit of Clause 18 or Clause 19, wherein
   no element is disposed between the interface circuit and the first keep-out zone.

While this disclosure has been described in connection with what is presently considered to be practical embodiments, it is to be understood that the disclosure is not necessarily limited to the disclosed embodiments, but, on the contrary, is intended to cover various modifications and equivalent dispositions included within the scope of the present disclosure.

## Claims

1. A three-dimensional, 3D, integrated circuit, comprising:
a first integrated circuit including a first substrate;
a second integrated circuit stacked on the first integrated circuit;
a through via extending through the first substrate and electrically connecting the first integrated circuit to the second integrated circuit; and
a plurality of protection circuits disposed at opposite sides of the through via in a keep-out zone surrounding the through via and electrically connected to the through via.

2. The 3D integrated circuit of claim 1, wherein the keep-out zone includes:
a first keep-out zone including an area spaced apart from an outer edge of the through via by a first distance in a first direction; and
a second keep-out zone including an area spaced apart from an outer edge of the of the through via by a second distance in the first direction, wherein the second distance is greater than the first distance,
wherein the plurality of protection circuits are disposed within the second keep-out zone.

3. The 3D integrated circuit of claim 2, further comprising
an interface circuit which is adjacent to a first protection circuit among the plurality of protection circuits in the first direction outside of the second keep-out zone, and configured to transmit and receive logic signals to and from the second integrated circuit through the through via.

4. The 3D integrated circuit of claim 3, wherein
the second keep-out zone includes a first area and a second area outside of the first keep-out zone at opposite sides of the through via, and
the first protection circuit is disposed in the first area, and a second protection circuit among the plurality of protection circuits is disposed in the second area.

5. The 3D integrated circuit of claim 3 or claim 4, wherein
the through via and the interface circuit are electrically connected to one another using a plurality of metal layers, and the protection circuits are electrically connected to the plurality of metal layers.

6. The 3D integrated circuit of any of claims 2-5, further comprising:
an interface circuit adjacent to the first keep-out zone outside of the second keep-out zone in a second direction perpendicular to the first direction, and configured to transmit and receive logic signals to and from the second integrated circuit through the through via.

7. The 3D integrated circuit of any of claims 2-6, wherein:
the first keep-out zone is an area that does not include a metal layer other than the metal layer connected to the through via, and
the second keep-out zone is an area in which an active semiconductor device is not disposed.

8. The 3D integrated circuit of any preceding claim, wherein
the protection circuits include an antenna protection circuit configured to provide antenna effect protection to the first integrated circuit.

9. The 3D integrated circuit of claim 8, wherein
the antenna protection circuit includes an antenna diode.

10. The 3D integrated circuit of any preceding claim, wherein
the plurality of protection circuits are electrostatic discharge, ESD, protection circuits configured to provide ESD protection to the first integrated circuit.

11. An integrated circuit, comprising:
a through extending through a first substrate;
a first keep-out zone disposed on the first substrate, and having a first boundary around the through via and spaced apart from the through via by a first distance in a first direction, and a second boundary spaced apart from the through via by a second distance in a second direction perpendicular to the first direction;
a second keep-out zone disposed on the first substrate, and having a third boundary around the through via and spaced apart from the through via by a third distance in the first direction, and a fourth boundary spaced apart from the through via by the second distance in the second direction;
a first protection circuit disposed outside of the first keep-out zone and inside of the second keep-out zone and electrically connected to the through via; and
an integrated circuit disposed outside of the second keep-out zone and including an interface circuit electrically connected to the through via.

12. The integrated circuit of claim 11, wherein
the third distance is greater than the first distance.

13. The integrated circuit of claim 11 or claim 12, wherein
the interface circuit, the first protection circuit, and the through via are sequentially arranged in the first direction.

14. The integrated circuit of any of claims 11-13, further comprising:
a second protection circuit disposed outside of the first keep-out zone and inside of the second keep-out zone, and disposed at an opposite side of the first protection circuit with respect to the through via.

15. The integrated circuit of any of claims 11-14, wherein
the interface circuit is disposed adjacent the first keep-out zone in the second direction.
